# EUROPÄISCHE PATENTANMELDUNG

(11) **EP 2 184 854 A1**
(43) Veröffentlichungstag der Anmeldung: **12.05.2010**
(21) Anmeldenummer: 09011904.1
(22) Anmeldetag: 18.09.2009
(51) Int. Cl.: H03K 3/356, H03K 17/10

(54) **Pegelschieber mit Natural-Transistoren**

(30) Priorität: 06.11.2008 DE 102008056131
(71) Anmelder: Micronas GmbH, 79108 Freiburg i. Br. (DE)
(72) Erfinder: Czech, Martin, 79427 Eschbach (DE); Giehl, Juergen, 79199 Kirchzarten (DE); Theus, Ulrich Dr., 79194 Gundelfingen (DE)
(74) Vertreter: Göhring, Robert

(57) **Zusammenfassung**

Pegelschieber zum Umsetzen eines Eingangssignals (in) aus einem ersten Betriebsspannungsbereich (I) mit einem ersten Grundpotential (VSS1) und einem ersten Betriebspotential (VDD1) in einen zweiten Betriebsspannungsbereich (II) mit einem zweiten Grundpotential (VSS2) und einem zweiten Betriebspotential (VDD2) mit einer Eingangsschaltung (1) an die das Eingangssignal (in) anlegbar ist und einer Ausgangsschaltung (2) an der das Ausgangssignal (out) abgreifbar ist, wobei die Eingangsschaltung (1) wenigstens einen Natural-Transistor (TT12, TT22) enthält.

## Beschreibung

Die Erfindung betrifft einen Pegelschieber gemäß dem Oberbegriff des Patentanspruchs 1.

Derartige Pegelschieber sind aus dem Stand der Technik beispielsweise aus der DE 10 2004 052 092 A1 zum Umsetzen eines Eingangssignals in aus einem ersten Betriebsspannungsbereich I mit einem ersten Grundpotential VSS1 und einem ersten Versorgungspotential VDD1 in ein Ausgangssignal out in einem zweiten Betriebsspannungsbereich II mit einem zweiten Grundpotential VSS2 und einem zweiten Versorgungspotential VDD2 bekannt.

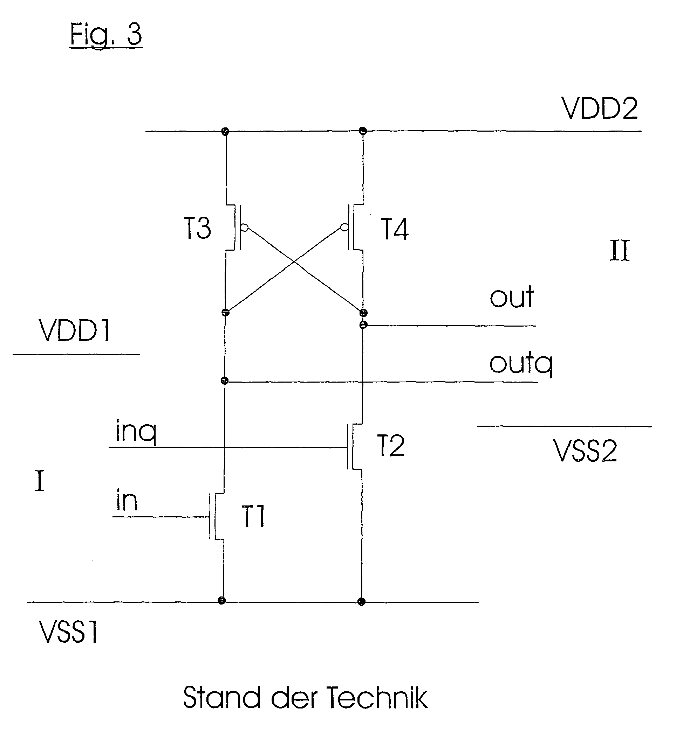

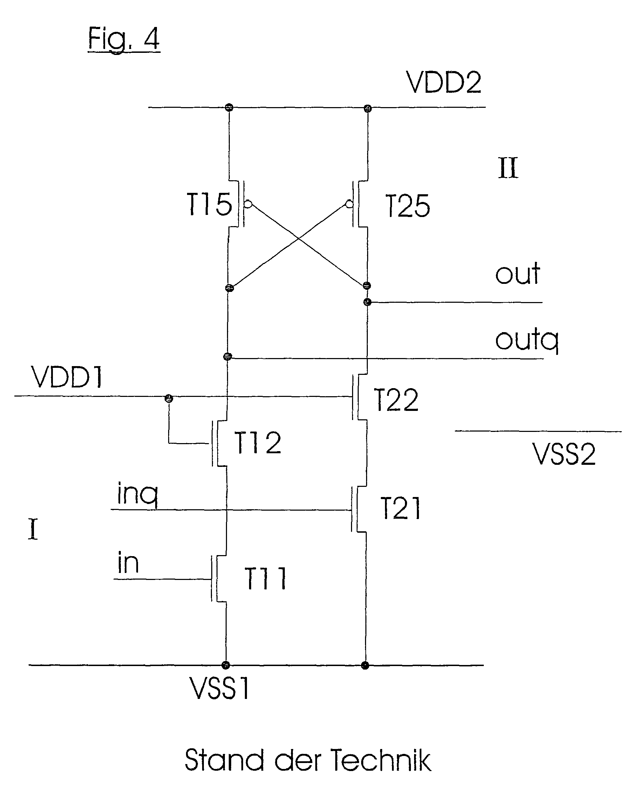

Aus dem Stand der Technik bekannte Pegelschieber sind beispielhaft in den Figuren 3 und 4 dargestellt.

Der Pegelschieber in Figur 3 ist als eine Parallelschaltung einer Reihenschaltung eines ersten Eingangstransistors T1 und eines ersten Ausgangsstransistors T3 mit einer Reihenschaltung eines zweiten Eingangstransistors T2 und eines zweiten Ausgangstransistors T4 aufgebaut und zur Versorgung zwischen das erste Grundpotential VSS1 und das zweite Versorgungspotential VDD2 geschaltet. Der erste Ausgangstransistor T3 und der zweite Ausgangstransistor T4 sind kreuzverkoppelt, d.h. ein Steuereingang des ersten Ausgangstransistors T3 ist mit einem Verbindungspunkt zwischen dem zweiten Eingangstransistor T2 und dem zweiten Ausgangstransistor T4 verbunden und ein Steuereingang des zweiten Ausgangstransistors T4 ist mit einem Verbindungspunkt zwischen dem ersten Eingangstransistor T1 und dem ersten Ausgangstransistor T3 verbunden. Einem Steuereingang des ersten Eingangstransistors T1 ist das Eingangssignal in direkt zuführbar, während es einem Steuereingang des zweiten Eingangstransistors T2 als invertiertes Eingangssignal inq zuführbar ist. An dem Verbindungspunkt zwischen dem zweiten Eingangstransistor T2 und dem zweiten Ausgangstransistor T4 ist ein Ausgangssignal out abgreifbar, während an dem Verbindungspunkt zwischen dem ersten Eingangstransistor T1 und dem ersten Ausgangstransistor T3 ein invertiertes Ausgangssignal outq abgreifbar ist.

Wird eingangsseitig beispielsweise ein high-Signal angelegt, so schaltet der erste Eingangstransistor T1 in einen leitenden Zustand und zieht den nachfolgenden Verbindungspunkt auf das erste Grundpotential VSS1. Der zweite Eingangstransistor T2, dem das invertierte high-Signal, also ein low-Signal, zugeführt wird, sperrt. Das an dem Verbindungspunkt zwischen dem ersten Eingangstransistor T1 und dem ersten Ausgangstransistor T3 anliegende erste Grundpotential VSS1 schaltet den zweiten Ausgangstransistor T4, der als p-Kanal-Transistor ausgebildet ist, in einen leitenden Zustand, so dass der Verbindungspunkt zwischen dem zweiten Eingangstransistor T2 und dem zweiten Ausgangstransistor T4 auf das zweite Versorgungspotential VDD2 angehoben wird. Durch das an dem Verbindungspunkt anliegende Potential wird der erste Ausgangstransistor T3, der ebenfalls als p-Kanal-Transistor ausgebildet ist, in einen sperrenden Zustand gebracht. Ausgangsseitig ist somit an dem Verbindungspunkt zwischen dem zweiten Eingangstransistor T2 und dem zweiten Ausgangstransistor T4 ein high-Signal, nämlich das zweite Versorgungspotential VDD2, als Ausgangssignal out abgreifbar. An dem Verbindungspunkt zwischen dem ersten Eingangstransistor T1 und dem ersten Ausgangstransistor T3 ist ausgangsseitig ein low-Signal, nämlich das erste Grundpotential VSS1, als invertiertes Ausgangssignal outq abgreifbar.

Liegt der erste Betriebsspannungsbereich I beispielsweise in einem Bereich von 0 bis 3 V und der zweite Betriebsspannungsbereich II in einem Bereich von 7 bis 12 V, so ist es außerdem notwendig, wie in Figur 4 dargestellt, den Eingangstransistor T1, T2 je durch eine Kaskode-Schaltung aus einem ersten Transistor T11, T21 und einem zweiten Transistor T12, T22 zum Überspannungsschutz zu ersetzen. Die Steuereingänge der zweiten Transistoren T12, T22 sind mit dem ersten Versorgungspotential VDD1 verbunden, so dass die beiden als n-Kanal-Transistor ausgebildeten zweiten Transistoren T12, T22 dauerhaft in einem leitenden Zustand sind. Die beiden ersten Transistoren T11, T21 sind technologisch derart beschaffen, dass sie die hohe Potentialdifferenz zwischen dem ersten Grundpotential VSS1 und dem zweiten Versorgungspotential VDD2 nicht unbeschadet überstehen. Durch die zweiten Transistoren T12, T22 wird dieser Nachteil behoben.

Ist bei einem Pegelschieber nach dem Stand der Technik eine Potentialdifferenz des ersten Betriebsspannungsbereiches I so klein, dass eine resultierende effektive Gatespannung Veff_{G} in der Nähe der Schwellspannung Vₜₕ der Eingangstransistoren T11 und T21 liegt, und kommen aufgrund einer großen Potentialdifferenz des zweiten Betriebsspannungsbereichs II keine Transistoren mit einer niedriger liegenden Schwellspannung Vth, die durch ein dünneres Gate-Oxid und eine angepasste Kanaldotierung erreicht wird, in Frage, so werden die aus dem Stand der Technik bekannten Pegelschieber nicht mehr funktionieren, da die effektive Gatespannung der Kasoden-Transistoren T12, T22 nicht mehr ausreichend groß ist. Die effektive Gate-Spannung Veff_{G} ist dabei als Differenz zwischen einer tatsächlich anliegenden Gate-Source-Spannung V_{GS} und der Schwellspannung Vₜₕ eines Transistors definiert.

Es ist die Aufgabe der vorliegenden Erfindung, einen Pegelschieber zur Verfügung zu stellen, der die Nachteile aus dem Stand der Technik nicht aufweist und auch bei einer geringen Potentialdifferenz im ersten Betriebsspannungsbereich I und einer großen Potentialdifferenz im zweiten Betriebsspannungsbereich II zuverlässig arbeitet.

Diese Aufgabe wird durch einen Pegelschieber mit den Merkmalen des Patentanspruchs 1 gelöst. Vorteilhafte Weiterbildungen der Erfindung sind Gegenstand von Unteransprüchen.

Ein erfindungsgemäßer Pegelschieber zum Umsetzen eines Eingangssignals aus einem ersten Betriebsspannungsbereich mit einem ersten Grundpotential und einem ersten Betriebspotential in ein Ausgangssignal in einem zweiten Betriebsspannungsbereich mit einem zweiten Grundpotential und einem zweiten Betriebspotential weist eine Eingangsschaltung, an die das Eingangssignal anlegbar ist, und eine Ausgangsschaltung, an der das Ausgangssignal abgreifbar ist, auf, wobei die Eingangsschaltung wenigstens einen Natural-Transistor enthält.

Der Vorteil in der Verwendung von Natural-Transistoren in der Eingangsschaltung liegt darin, dass diese in einem Fertigungsprozess geeignet dimensioniert werden können, dass sie für eine hohe Potentialdifferenz auf ihre Laststrecke geeignet sind und gleichzeitig eine niedrige Schwellspannung aufweisen. Natural-Transistoren werden ohne eine zusätzliche Schwellspannungsimplantation im Kanalbereich hergestellt und weisen daher eine natürliche Schwellspannung des Fertigungsprozesses auf. Typischerweise liegt diese natürliche Schwellspannung im Bereich von etwa 0 Volt.

Durch die Verwendung von Natural-Transistoren in der Eingangsschaltung können Pegelschieber aufgebaut werden, die mit einer geringen Potentialdifferenz im ersten Versorgungsspannungsbereich geschaltet werden und eine große Potentialdifferenz im zweiten Versorgungsspannungsbereich schalten können.

Die Eingangsschaltung des Pegelschiebers weist bevorzugt zwei parallel geschaltete Eingangsstufen auf, die je wenigstens einen Natural-Transistor aufweisen. Beispielsweise können die Eingangsstufen als Kaskode-Schaltungen ausgebildet sein, die einen ersten Transistor und einen zweiten Transistor in Kaskode-Schaltung aufweisen, wobei der erste Transistor für den ersten Betriebsspannungsbereich geeignet ist und der zweite Transistor für den zweiten Betriebsspannungsbereich geeignet und als Natural-Transistor ausgebildet ist.

Die in der Kaskode-Schaltung in Gate-Schichtung verschalteten Natural-Transistoren gewährleisten, dass die Senkung der ersten Transistoren nicht auf das zweite Versorgungspotential gelangen und schützen diese dadurch vor Zerstörung. Dadurch dass die Natural-Transistoren für den zweiten Betriebsspannungsbereich ausgelegt sind, überstehen sie unbeschadet die hohe Potentialdifferenz und können durch ihre niedrige Schwellspannung mit dem ersten Versorgungspotential leitend geschaltet werden. Der grundlegende Gedanke der Erfindung liegt dabei darin, dass eine effektive Gatespannung, die als Differenz einer Gate-Source-Spannung und einer Schwellspannung eines Transistors definiert ist, durch die Verringerung der Schwellspannung des Transistors auch in dem ersten Betriebsspannungsbereich verfügbar ist.

In einer Weiterbildung der Erfindung klemmt ein Verbindungsknoten zwischen dem ersten Transistor und dem zweiten Transistor auf das erste Versorgungspotential. Eine derartige Klemmung kann beispielsweise durch einen als Diode geschalteten dritten Transistor, der beispielsweise als p-Kanal-Transistor ausgebildet sein kann oder eine Diode realisiert werden. Wird zur Klemmung beispielsweise ein als Diode geschalteter p-Kanal-Transistor verwendet, so können der erste Transistor und der dritte Transistor der Eingangsstufen jeweils als Inverter verschaltet sein.

Zur Vermeidung von Kriechströmen aus dem zweiten Betriebsspannungsbereich in den ersten Betriebsspannungsbereich können die Kaskode-Schaltungen je einen vierten Transistor aufweisen, der zwischen den ersten Transistor und den zweiten Transistor geschaltet ist. Ein Steueranschluss des vierten Transistors, der als n-Kanal-Transistor ausgebildet sein kann, ist mit dem ersten Versorgungspotential verbunden, so dass eine Kaskode-Schaltung mit zwei n-Kanal-Transistoren und einem Natural-Transistor gebildet ist. Die vierten Transistoren verhindern durch ihren Schwellspannungsabfall, dass ein Verbindungsknoten des ersten und dritten Transistors auf ein Potential über dem ersten Versorgungspotential gezogen wird und begrenzen damit die Kriechströme zwischen dem ersten und dem zweiten Betriebspotential auf wenige µ-Ampere.

Zum Schutz gegen elektrostatische Zerstörungen können die Eingangsschaltung und/oder die Ausgangsschaltung verschiedene Schutzschaltungen aufweisen.

Beispielsweise kann zur Verhinderung von zu großen Spannungen zwischen dem ersten Grundpotential und dem zweiten Grundpotential eine Schaltung aus zwei antiparallel geschalteten Dioden oder entsprechend als Diode geschalteten Transistoren vorgesehen sein. Des Weiteren kann eine Potentialdifferenz des ersten Betriebsspannungsbereichs durch eine erste Klemmschaltung und eine Potentialdifferenz des zweiten Betriebsspannungsbereichs durch eine zweite Klemmschaltung begrenzt sein, die jeweils zwischen dem Grundpotential und dem Versorgungspotential angeordnet ist. Das Ausgangssignal kann des Weiteren durch Klemmdioden oder als Diode geschaltete Transistoren auf den zweiten Betriebsspannungsbereich beschränkt werden, so dass am Ausgang keine zerstörerischen Spannungen anliegen können.

Der erfindungsgemäße Pegelschieber eignet sich besonders für Betriebsspannungsbereiche, bei denen eine Differenz des ersten Betriebspotentials und des ersten Grundpotentials im Bereich der Schwellspannung der ersten Transistoren liegt, da genau bei diesen Spannungsverhältnissen die aus dem Stand der Technik bekannten Pegelschieber nicht mehr zufriedenstellend funktionieren.

Der Pegelschieber ist besonders gut als Aufbau aus MOS-Transistoren zu realisieren, wobei die Ausgangsschaltung aus zwei kreuzverkoppelten MOS-Transistoren aufgebaut ist.

Die Erfindung wird nachfolgend anhand eines Ausführungsbeispiels unter Bezugnahme auf die beigefügten Figuren eingehend erläutert. Es zeigen:
- Figur 1: ein erstes Ausführungsbeispiel eines erfindungsgemäßen Pegelschiebers,
- Figur 2: ein zweites, gegenüber Figur 1 erweitertes Ausführungsbeispiel eines erfindungsgemäßen Pegelschiebers,
- Figur 3: einen Pegelschieber nach dem Stand der Technik (schon behandelt) und
- Figur 4: einen Pegelschieber nach dem Stand der Technik mit Kaskode-Schaltung (schon behandelt).

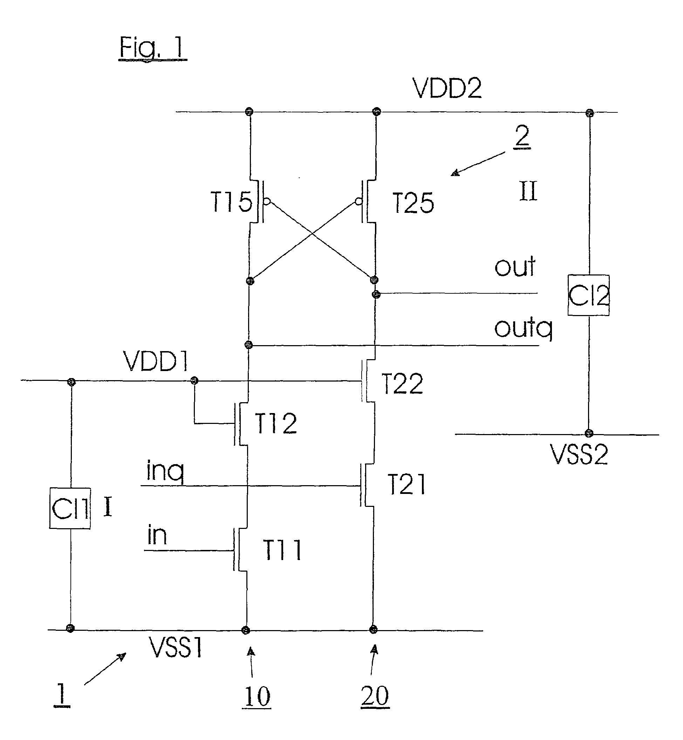

Figur 1 zeigt einen Pegelschieber mit einer Eingangschaltung 1 und einer Ausgangsschaltung 2 zur Umsetzung eines Eingangssignals in aus einem ersten Betriebsspannungsbereich I in ein Ausgangssignal out in einem zweiten Betriebsspannungsbereich II. Der erste Betriebsspannungsbereich weist dabei ein erstes Grundpotential VSS1 und ein erstes Betriebspotential VDD1 auf. Der zweite Betriebsspannungsbereich entsprechend ein zweites Grundpotential VSS2 und ein zweites Betriebspotential VDD2. Die Eingangsschaltung 1 ist aus zwei parallel geschalteten Eingangsstufen 10, 20 aufgebaut, die jeweils als Kaskode-Schaltungen aus einem ersten Transistor T11, T21 in Source-Schaltung und einem zweiten Transistor T12, T22 in Gate-Schaltung aufgebaut sind. Das Eingangssignal in ist einem der beiden ersten Transistoren T11, T21 direkt und dem anderen invertiert zuführbar, wobei es jeweils einem Gate-Anschluss der Transistoren anlegbar ist. Die zweiten Transistoren T12, T22 sind als sogenannte Natural-Transistoren ausgebildet und mit einem Gate-Anschluss mit dem ersten Versorgungspotential VDD1 verbunden. Natural Transistoren sind MOS-Transistoren, bei denen die Kanal-Dotierung in etwa der Substrat-Dotierung entspricht, so dass die Schwellspannung des Transistors in etwa bei 0 V liegt. Die Ausgangsstufe ist durch fünfte Transistoren T15, T25 gebildet. Die fünften Transistoren T15, T25 sind als p-Kanal-Transistoren ausgebildet und miteinander kreuzverkoppelt, d.h. dass je ein Gateanschluss des einen fünften Transistors T15 mit einem Source-Anschluss des anderen fünften Transistors T25 verbunden ist. An den Source-Anschlüssen der fünften Transistoren T15, T25 ist das Ausgangssignal out einmal direkt und einmal als invertiertes Ausgangssignal outq abgreifbar. Eine Potentialdifferenz des ersten Betriebsspannungsbereichs I kann durch eine erste Klemmschaltung CL1 begrenzt sein. Das Gleiche ist für eine Potentialdifferenz des zweiten Betriebsspannungsbereichs mit einer zweiten Klemmschaltung CL2 vorgesehen.

Durch die Verwendung von Natural-Transistoren als zweite Transistoren T12, T22 in den Kaskode-Schaltungen der Eingangsstufen 10, 20 ist es möglich, die ersten Transistoren T11, T21 technologisch für den ersten Betriebsspannungsbereich I auszulegen und durch die Natural-Transistoren T12, T22 zu verhindern dass Drain-Anschlüsse der ersten Transistoren mit einer großen Potentialdifferenz zwischen dem zweiten Betriebspotential VDD2 und dem ersten Versorgungspotential VSS1 zu belasten. Die Natural-Transistoren T12, T22 können technologisch für den zweiten Betriebsspannungsbereich II ausgelegt sein und weisen dennoch eine Schwellspannung Vₜₕ auf, die im ersten Betriebsspannungsbereich I erreicht werden kann.

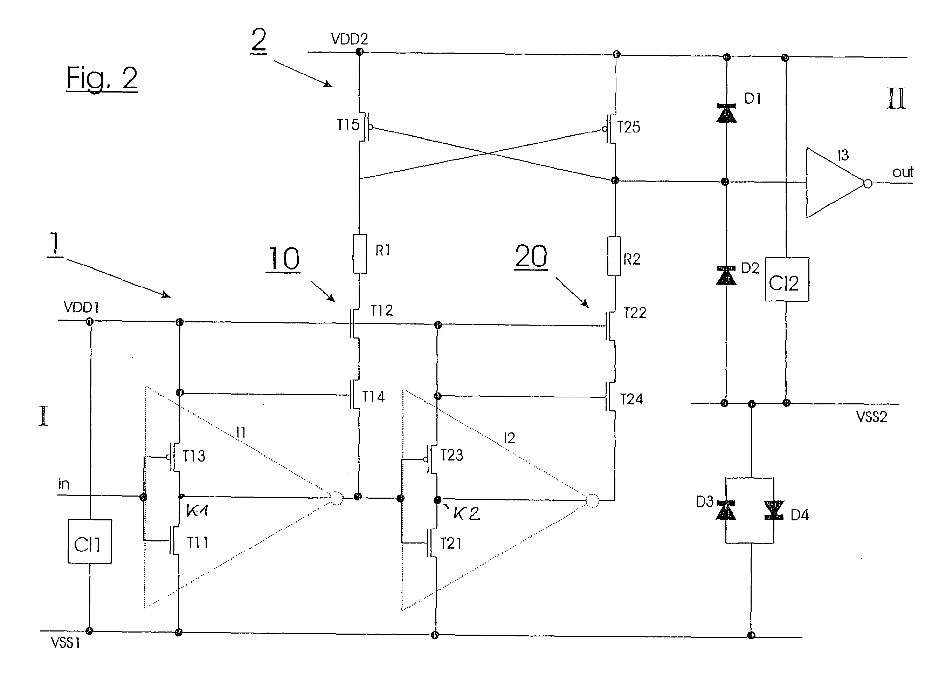

Figur 2 zeigt den Pegelschieber aus Figur 1, wobei die dort gezeigte Schaltung um verschiedene Elemente erweitert ist. Identische Bauelemente sind dabei identisch zu Figur 1 bezeichnet.

Die Eingangsstufen 10, 20 sind je um einen dritten Transistor T13, T23 sowie um einen vierten Transistor T14, T24 erweitert. Der dritte Transistor T13, T23 ist dabei als p-Kanal-Transistor ausgebildet und zwischen einen Drain-Anschluss des ersten Transistors T11, T21 und das erste Versorgungspotential VDD1 geschaltet. Einem Gate-Anschluss des dritten Transistors T13, T23 ist dabei das Eingangssignal des jeweils ersten Transistors T11, T21 zugeführt, so dass jeweils der erste Transistor T11, T21 und der dritte Transistor T13, T23 als Inverter verschaltet sind. Einem dadurch gebildeten ersten Inverter I1 ist das Eingangssignal in zugeführt, wohingegen einem zweiten Inverter I2 das Ausgangssignal des ersten Inverters I1 zugeführt ist. Durch die als p-Kanal-Transistor ausgebildeten dritten Transistoren T13, T23 klemmen die Drain-Anschlüsse der ersten Transistoren T11, T21 auf das erste Versorgungspotential VDD1.

Die vierten Transistoren T14, T24 sind zur Verhinderung von Kriech-Strömen zwischen dem zweiten Versorgungsspannungsbereich und dem ersten Versorgungsspannungsbereich in Gate-Schaltung zwischen die ersten Transistoren T11, T21 und die zweiten Transistoren T12, T22 geschaltet und mit dem ersten Versorgungspotential VDD1 verbunden.

Zur Strombegrenzung sind zwischen der Eingangsschaltung 1 und der Ausgangsschaltung 2 ein erster Widerstand R1 und ein zweiter Widerstand R2 angeordnet. Die Widerstände R1, R2 begrenzen Stromspitzen bei ESD-Ereignissen (Electrostatic Discharge) und verhindern damit in Verbindung mit weiteren Schaltungsteilen die Zerstörung des Pegelschiebers bei elektrostatischen Entladungen. Zur Begrenzung des Ausgangssignals out auf den zweiten Betriebsspannungsbereich II sind eine erste Klemmdiode D1 und eine zweite Klemmdiode D2 vorgesehen. Die Klemmdioden D1, D2 sind zwischen einem Abgriff für das Ausgangssignal out und dem zweiten Betriebspotential VDD2 sowie zwischen dem Abgriff für das Ausgangssignal out und dem zweiten Grundpotential VSS2 angeordnet. Zur Ausnutzung des vollen Spannungshubs des zweiten Betriebsspannungsbereichs II kann ausgangsseitig ein dritter Inverter I3 vorgesehen sein. Um große Potentialdifferenzen zwischen dem ersten Grundpotential VSS1 und dem zweiten Grundpotential VVS2 zu vermeiden, sind zwischen diesen Potentialen eine dritte und eine vierte Diode D3, D4 vorgesehen, die antiparallel geschaltet sind. Durch die Dioden D3, D4 ist ein Ladungsausgleich zwischen den Grundpotentialen VSS1, VSS2 möglich, so dass das Auftreten von großen Spannungen vermieden wird.

### Bezugszeichenliste

- T1: erster Eingangstransistor
- T2: zweiter Eingangstransistor
- T3: erster Ausgangstransistor
- T4: zweiter Ausgangstransistor
- T11/T21: erster Transistor
- T12/T22: zweiter Transistor
- T13/T23: dritter Transistor
- T14/T24: vierter Transistor
- T15/T25: fünfter Transistor

- D1: erste Diode
- D2: zweite Diode
- D3: dritte Diode
- D4: vierte Diode

- I1: erster Inverter
- I2: zweiter Inverter
- I3: dritter Inverter

- in: Eingangssignal
- out: Ausgangssignal
- inq: invertiertes Eingangssignal
- outq: invertiertes Ausgangssignal

- 10: erste Eingangsstufe
- 20: zweite Eingangsstufe

- I: erster Betriebsspannungsbereich
- II: zweiter Betriebsspannungsbereich

- 1: Eingangsschaltung
- 2: Ausgangsschaltung

- C11: erste Klemmschaltung
- C12: zweite Klemmschaltung

- R1: erster Widerstand
- R2: zweiter Widerstand

- VDD1: erstes Versorgungspotential
- VDD2: zweites Versorgungspotential
- VSS1: erstes Betriebspotential
- VSS2: zweites Betriebspotential

- K1: erster Verbindungsknoten
- K2: zweiter Verbindungsknoten

## Patentansprüche

1. Pegelschieber zum Umsetzen eines Eingangssignals (in) aus einem ersten Betriebsspannungsbereich (I) mit einem ersten Grundpotential (VSS1) und einem ersten Betriebspotential (VDD1) in ein Ausgangssignal (out) in einem zweiten Betriebsspannungsbereich (II) mit einem zweiten Grundpotential (VSS2) und einem zweiten Betriebspotential (VDD2) mit einer Eingangsschaltung (1) an die das Eingangssignal (in) anlegbar ist und einer Ausgangsschaltung (2) an der das Ausgangssignal (out) abgreifbar ist,
**dadurch gekennzeichnet, dass**
die Eingangsschaltung (1) wenigstens einen Natural-Transistor (T12, T22) enthält.

2. Pegelschieber nach Anspruch 1,
**dadurch gekennzeichnet, dass**
die Eingangsschaltung (1) zwei parallel geschaltete Eingangsstufen (10, 20) aufweist, die je wenigstens einen Natural-Transistor (T12, T22) aufweisen.

3. Pegelschieber nach Anspruch 2,
**dadurch gekennzeichnet, dass**
die Eingangsstufen (10, 20) als Kaskode-Schaltungen ausgebildet sind.

4. Pegelschieber nach Anspruch 3,
**dadurch gekennzeichnet, dass**
die Kaskode-Schaltungen einen ersten Transistor (T11, T21) und einen zweiten Transistor (T12, T22) aufweisen, wobei der erste Transistor (T11, T21) für den ersten Betriebsspannungsbereich (I) geeignet ist und der zweite Transistor (T12, T22) für den zweiten Betriebsspannungsbereich (II) geeignet und als Natural-Transistor ausgebildet ist.

5. Pegelschieber nach Anspruch 4,
**dadurch gekennzeichnet, dass**
zwischen einem Verbindungsknoten (K1, K2)zwischen dem ersten Transistor (T11, T21) und dem zweiten Transistor (T12, T22) und dem ersten Versorgungspotential (VDD1) eine Klemmschaltung angeordnet ist.

6. Pegelschieber nach Anspruch 5,
**dadurch gekennzeichnet, dass**
die Klemmschaltung ein dritter Transistor (T13, T23) ist, der für den ersten Betriebsspannungsbereich (I) ausgelegt ist.

7. Pegelschieber nach Anspruch 6,
**dadurch gekennzeichnet, dass**
der erste Transistor (T11, T21) und der dritte Transistor (T13, T23) der Eingangsstufen (10, 20) jeweils als Inverter (11, 12) verschaltet sind.

8. Pegelschieber nach Anspruch 5,
**dadurch gekennzeichnet, dass**
zur Klemmung je eine Diode vorgesehen ist, die zwischen den Verbindungsknoten (K1, K2) und das erste Versorgungspotential (VDD1) geschaltet ist.

9. Pegelschieber nach einem der Ansprüche 3 bis 7,
**dadurch gekennzeichnet, dass**
die Kaskode-Schaltungen einen vierten Transistor (T14, T24) aufweisen, der zwischen den ersten Transistor (T11, T21) und den zweiten Transistor (T12, T22) geschaltet ist.

10. Pegelschieber nach einem der vorhergehenden Ansprüche,
**dadurch gekennzeichnet, dass**
die Eingangsschaltung (1) und/oder die Ausgangsschaltung (2) Schutzschaltungen (C11, C12, D1, D2, D3, D4) gegen elektrostatische Zerstörung aufweisen.

11. Pegelschieber nach einem der vorhergehenden Ansprüche,
**dadurch gekennzeichnet, dass**
zwischen dem ersten Grundpotential (VSS1) und dem zweiten Grundpotential (VSS2) zwei antiparallel geschaltete Dioden (D3, D4) vorgesehen sind.

12. Pegelschieber nach einem der vorhergehenden Ansprüche,
**dadurch gekennzeichnet, dass**
zwischen der Eingangsschaltung (1) und der Ausgangsschaltung (2) Widerstände (R1, R2) zur Strombegrenzung vorgesehen sind.

13. Pegelschieber nach einem der Ansprüche 4 bis 12,
**dadurch gekennzeichnet, dass**
eine Differenz des ersten Betriebspotentials (VDD1) und des ersten Grundpotentials (VSS1) im Bereich einer Schwellspannung (Vth11, Vth21) des ersten Transistors (T11, T21) liegt.

14. Pegelschieber nach einem der vorstehenden Ansprüche,
**dadurch gekennzeichnet, dass**
der Pegelschieber mit MOS-Transistoren aufgebaut ist.

15. Pegelschieber nach einem der vorhergehenden Ansprüche,
**dadurch gekennzeichnet, dass**
die Ausgangsschaltung (2) aus zwei Kreuzverkoppelten MOS-Transistoren aufgebaut ist.
